(19) **Europäisches Patentamt**

**European Patent Office**

**Office européen des brevets**

(11) **EP 0 718 979 B1**

(12) **EUROPEAN PATENT SPECIFICATION**

(45) Date of publication and mention
of the grant of the patent:
**03.05.2000 Bulletin 2000/18**

(51) Int Cl.⁷: **H03L 7/099**, H04N 9/45

(21) Application number: **95309406.7**

(22) Date of filing: **22.12.1995**

(54) **Television standard discrimination circuit**

Diskriminatorschaltung für Fernsehnormen

Circuit discriminateur de standard de télévision

(84) Designated Contracting States:
**DE FR NL**

(30) Priority: **22.12.1994 JP 32036994**

(43) Date of publication of application:
**26.06.1996 Bulletin 1996/26**

(73) Proprietor: **KABUSHIKI KAISHA TOSHIBA**
**Kawasaki-shi, Kanagawa-ken 210-8572 (JP)**

(72) Inventor: **Murayama, Akihiro**
**Tokyo (JP)**

(74) Representative: **Muir, Ian R.**
**Haseltine Lake & Co.,**
**Imperial House,**
**15-19 Kingsway**
**London WC2B 6UD (GB)**

(56) References cited:
**EP-A- 0 492 588** **US-A- 4 965 533**

Printed by Jouve, 75001 PARIS (FR)

## Description

The present invention relates to a discriminator circuit which is suitable for multiple systems ready color television receivers.

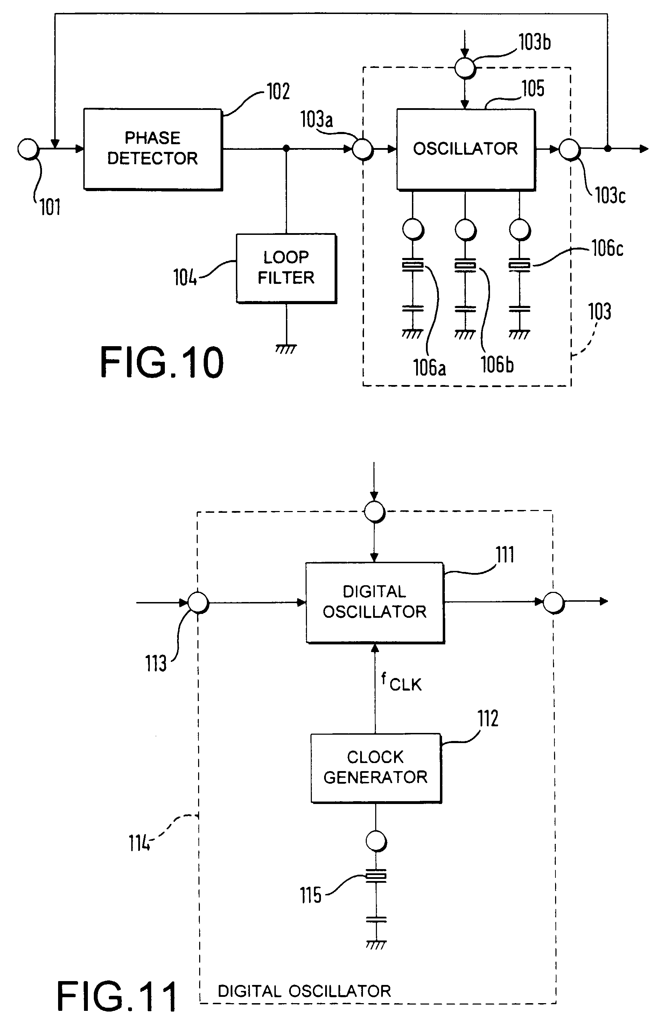

There are three standard, i.e., the NTSC, the PAL and the SECAM in the modulation systems of the television signal. In some areas where a plurality of systems are able to be received multiple systems ready color television receivers can be utilized. Among three systems as mentioned above, the PAL system uses different color subcarrier frequencies (fsc) in accordance with areas. For example, in South America the NTSC system, the M-PAL and the N-PAL systems are mixed. For receiving a croma signal by such TV receivers it is necessary to reproduce the color subcarrier from a transmitted burst signal. Usually, a chrominance signal processing circuit in the analog system receiver is provided a plurality of quartz oscillators (X'tals) each associated with a prescribed chrominance signal frequency and selectively uses the quartz oscillator to generates a desired color subcarrier. The system will be described in reference to FIGURE 10.

In FIGURE 10 a burst signal input to an input terminal 101 is supplied to one input terminal of a phase detector 102. An output of the phase detector 102 is applied to a frequency control terminal 103a of a quartz oscillator circuit 103 and to a loop filter 104. Quartz oscillators 106a to 106c which are used for an oscillation are connected to an oscillator 105 which varies the frequency by the control signal supplied to the frequency control terminal 103a. A control terminal 103b in the quartz oscillator circuit 103 connects a desired quartz oscillator among these quartz oscillators 106a to 106c to the oscillator 105 by a control signal from outside. An output of the oscillator 105 is supplied to an output terminal 103c as an output of the quartz oscillator circuit 103, from here, the output is supplied to the other input of the phase detector 102.

The conventional apparatus operates to lock the phases of the input burst signal and the output of the quartz oscillator circuit 103 with each other. When these phases are matched with each other the chrominance demodulating circuit of the system is operated to modulate a color difference signal. The PLL loop which is necessary for reproducing of the color subcarrier is called to an APC loop or an APC circuit.

When the system as described above is individually constructed for different areas there will be many types of chassises of the TV receivers so that the manufacturing process at the producer side will be complicated. So, these day there is a tendency to standardize the chassis for all of the world. Further, there was a problem that the chassis for South America has been cost-expensive since it needed three expensive quartz oscillators, as shown in FIGURE 10.

Generally, the multi color systems ready TV means a system which is able to receive both PAL/NTSC systems. In this case of TV still needs two quartz oscillators. While the SECAM system adapts a FM modulation system different from other systems, so that it takes different chrominance demodulation processing. So, it has a processing circuit in addition to the those for the PAL and NTSC systems, and it does not need the oscillation circuit. Accordingly, the oscillation circuit needs to accommodate four frequencies of a BG-PAL system (4.43 MHz), an M-PAL system (3.575 MHz), an N-PAL system (3.582 MHz) and the NTSC system (3.579 MHz).

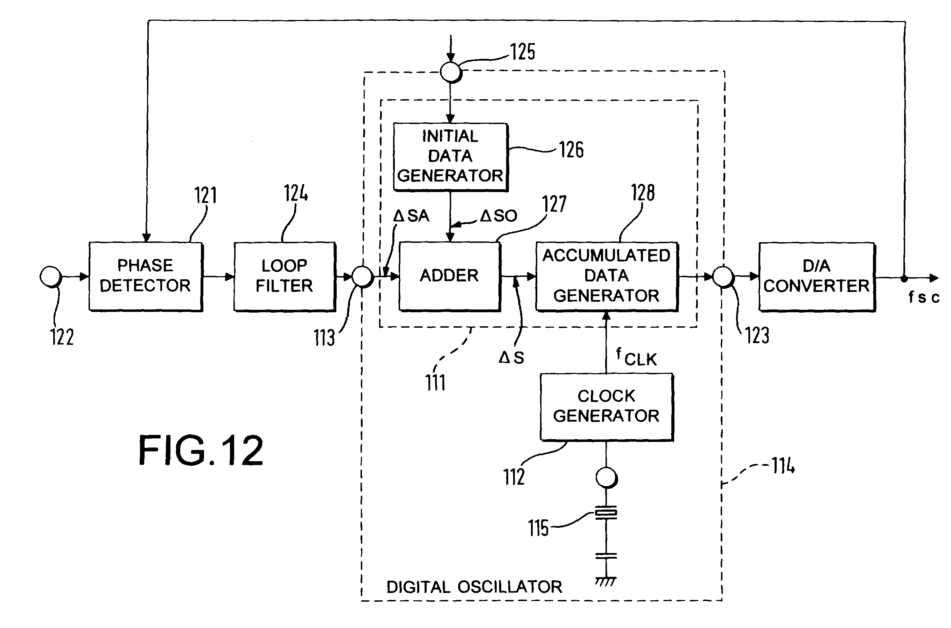

In such an environment as described above, these day a system accommodating not an analog technique as shown in FIGURE 10 but a digital technique as shown in FIGURE 11 is introduced. The digital system is mentioned in "direct processing digital synthesizer" in "Design and Application of Oscillators", pp. 305-329 issued by CQ Publishing Co. Ltd. Here, the digital system will be called as a "digital oscillator circuit" and incorporated herein in place of the quartz oscillator circuit 103 in the analog TV receiver, as shown in FIGURE 10.

In FIGURE 11, a clock signal fCFK generated in a clock generator 112 is supplied to a digital oscillator 111 as a master clock. And, the oscillation frequency is varied by a data supplied from a frequency control data input terminal 113 of the digital oscillator 111. As a digital oscillator 114, which will be described in detail later, can accurately change its oscillation frequency to any given value by changing data, it can generate all of the four color subcarrier frequencies fsc. The system, as shown in FIGURE 11, needs only one quartz oscillator 115 for the master oscillation, so that it can achieve the standardization and the cost reduction at a same time.

Peripheral parts of the APC in the chrominance signal processing part will be explained in reference to FIGURE 12. In FIGURE 12 a digital oscillator system is constructed on a chassis accommodating a digital circuit. The same elements as these shown in FIGURE 11 are assigned with the same reference numerals.

Only the burst signal is extracted from the analog composite video signals and carried out an A/D conversion by an A/D convertor (not shown). A digital phase detector 121 compares the phases of the digitized burst signal supplied to an input terminal 122 with the output of the digital oscillator 111 lead to an output terminal 123. The comparison result data ∆SA is supplied to a frequency control terminal 113 of the digital oscillator 111 through a loop filter 124. Besides the comparison result data ∆SA, a control signal for changing color subcarrier frequencies fsc in suited for the prescribed system is supplied to an initial data generator 126 from a control terminal 125. The initial data generator 126 generates initial data ∆SO for obtaining each oscillation frequency fsc and applies each color subcarrier frequency fsc to an adder 127. The initial data ∆SO and the comparison result data ∆SA are added in the adder 127 and then the resulted sum data ∆S from the adder 127 is input to a data accumulator 128. The data accumulator 128 outputs an oscillation data under the control of the master clock fCLK from the clock generator 115.

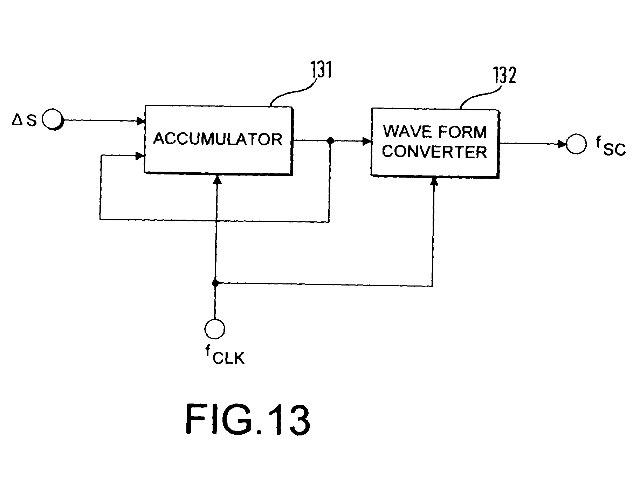

Before explaining about the APC operation, the operation of the data accumulator 128 will be explained in reference to FIGURE 13. The data accumulator 128 comprises an accumulator 131 and a waveform converter 132, as mentioned in the above-referenced document. The accumulator 131, which comprises a full adder and a latch, adds the recent output sum data and the sum data $\Delta S$ at every one clock of the master clock fCLK. In such a construction as described above, the output of the accumulator 131 will be increased by the amount of the sum data $\Delta S$ at every the every master clock fCLK, and it will cause an overflow of data in the end. Then, it looks that the data drops toward 0 and presents a sawtooth waveform. Accordingly, if the master clock fCLD is constant and once the bit length of the adder has been fixed, the interval causing the overflow is varied by changing the sum data $\Delta S$. Regarding the interval as an oscillation frequency, the oscillating frequency can be controlled by the sum data $\Delta S$. Here, the output data of the accumulator 131 has a sawtooth waveform, though generally it is desirable to provide a sinusoidal waveform signal to the APC circuit. This is because that the sawtooth wave contains a large amount of noise to make difficult the normal phase detecting operation of the APC. So, the sawtooth waveform data sequence is replaced by the sinusoidal waveform signal in the waveform converter.

Many of embodiments of the waveform converter used in this case are realized by sinusoidal waveform data storing ROMs, as mentioned in document. In the sinusoidal waveform data storing ROM the sinusoidal waveform data is stored by associating addresses in advance. Then the sinusoidal waveform data are read by assuming the sawtooth waveform data sequence as the addresses. According to the assumption, the sawtooth waveform data sequence is changed to the sinusoidal waveform data sequence so that it can output the signal suitable for the APC. Since the phase detector multiplies the burst signal and the oscillating signal generated in the digital generator, it has basically no problem when the phase of the oscillating signal is fixed. It is most stable to use a 50 % duty signal in the sinusoidal waveform data storing ROM mentioned here. If only the basic operation is discussed the waveform need not to changed to the sinusoidal waveform, it can be changed to a triangular wave or short from wave. Here, the waveform conversion is not specified to the sinusoidal waveform data storing ROM to take it in the wide sense.

The oscillation frequency control of the digital oscillator 114 is realized by changing the sum data $\Delta S$. However, since the APC circuit operate to lead the frequency in it the data for establishing the initial frequency and the data for changing the frequency little are treated separately. The initial frequency, that is the free run frequency is established by the initial data $\Delta SO$ and the

data for changing the frequency is established by the comparison result data $\Delta SA$. The phase detector 121 is a phase comparator and multiplies the burst signal and the output signal of the data accumulator 128. Only the data at a low frequency is extracted through a loop filter circuit 124 by the multiplied result. Since the extracted data varies a little the oscillation frequency of the digital oscillator 114 is made equal to the burst frequency to finally synchronize with the burst frequency. Thus, the color subcarrier frequency fsc equal to the burst frequency is reproduced.

In the system using the digital oscillator 114 as described above, since the data frequency oscillated in the digital oscillator 114 is defined by the initial data $\Delta S$, i.e., the digital data, the bit length needed in the data accumulator 128 for obtaining a required resolution becomes extremely large and it causes a problem of a large scale circuit, that is a high cost. Since the frequency is controlled by the digital data the oscillation frequency takes only the discrete value and it does not accord to the input burst frequency accurately. Accordingly, the output data of the phase detector 121 causes a frequency jump corresponding to at least one bit of data and change of the oscillation frequency of the digital oscillator 114 each phase detection (one time each one horizontal line). Since the change of the oscillation frequency leads the phase change of the color subcarrier signal fsc and also the change of the demodulated color phase. To check the phase difference the extent that it is not see by human eyes when it is received, it is necessary to check the effect of the frequency jump corresponding to one bit of data as small as possible. It is assumed that the 0.4 degree is a detection limit by the end of one line video signal since the burst is detected. It is about 30 Hz in the frequency of the color subcarrier fsc.

This is the bit resolution of the digital oscillator 114. If the bit length has an N bit size it is necessary to set the master clock $fCLD/2^N$ below 30 Hz. When the master clock fCLD is assumed as 16 MHz N will be 19. When a margin from a detection limit is considered N will be around 22 to 24. Whether the accumulator 131 having so many bits can be added by the master clock fCLK at once will be rely on the speed of the accumulator 131.

However, since it is difficult to process the addition at once in the present device technique, the addition is usually performed by being divided into an upper bit part and a lower bit part so that the added data in the lower bit part is carried to the upper bit part by the next clock and added. The added data in the lower bit part is delayed by the latch so as to align the timings of all bit of the adding output timing. The faster the clock becomes, the smaller the bit have to be defined. Further, the faster the clock becomes, the more the added output in the lower bit part delays by the latch and the more the number of stages of the latch will be, so that the stages of the latches will be increased aside from the main body, i.e., the adder 127.

Further, if the phase detector 121 is configured by a digital circuit, since the operation is operated by a multiplication process the output will be delayed by the step of the clock frequency. In addition, the APC information is supplied to the digital oscillator delayed for some clocks by the output delay for taking a timing of the comparison result data ΔSA and the initial data ΔSO in the adder 127, it seriously effects the APC pull-in time. In the case of the analog APC in FIGURE 10 since the multiplication processing is performed in real time it does not cause to delay the clock. In the cases of FIGURES 10 and 11, since the loop filter is located after the phase detector only low frequency components of the detected APC pass through the filter. Here, the delay time also presents but both the delays in the analog system and the digital system become equal, so it can be neglected. The delay of the signal over the phase detection to the digital oscillator results to cause the APC pull-in time longer.

Empirically, in the case of the analog APC system the APC pull-in operation completes within four fields, however in the case of the digital system in FIGURE 12 it extends over about eight fields. When the color subcarrier signal fsc to be received is limited to one like receivers for Japan the time difference between four fields and eight fields, in other wards, the coloring time required at a channel changing operation is not a big problem. However, in the case of the multi color systems ready receiver it will be a big problem. That is, as shown in FIGURE 10 when there is a difference between the frequency oscillated from the oscillator 105 and the burst frequency it repeats the change of the quartz oscillators such that it changes the quartz oscillators after a time and performs the APC detection again with other quartz oscillator. Since the quartz oscillators are not changed in APC pull-in time the time for changing the quartz oscillators will take a time the same or longer than the quartz oscillator changing time.

For example, if the cycle equals to eight fields, the changing operation of three quartz oscillators takes 31 fields long in maximum until the completion of the APC pull-in operation. It corresponds to 0.5 seconds, so that it makes viewers to feel nervous. In the case of the analog circuit similarly to the digital circuit when the cycle equals to four fields it takes 15 fields in maximum and it corresponds to 0.25 seconds. The difference of the 0.25 seconds has a great effect on visual sense since the difference is discriminated by a human. In other words, a human eye sharply responds the time differences. Practically, since the quartz oscillator changing cycle takes longer than the frequency pull-in time the absolute time will be expanded. In other words, the degree of feeling the time dull will be increased.

As described above, the conventional oscillator using the full digital APC system configured by direct composition system digital synthesizers has drawbacks such as a slow APC pull-in operation, a low precision, a large circuit scale (23 bits) or a cost-up, although it needs only one quartz oscillator in the multi-standards ready television receiving system.

EP0492588 discloses a frequency tracking device including a VCO and a direct digital synthesiser within a phase locked loop. A DC signal representative of the phase difference between an input signal and the output of the digital synthesiser is applied to the VCO to form a clock pulse for the direct digital synthesiser. A digital frequency command word is also applied to the digital synthesiser. The digital frequency command word enables a coarse tuning of the output of the digital synthesiser to the input signal, whilst the clock pulse supplied by the VCO enables a fine tuning of the digital synthesiser to the input signal.

According to the present invention, there is provided a discriminator circuit, characterised in that it comprises:

an oscillator, comprising a clock generator for generating a clock signal having a frequency controllable by means of a frequency control signal, and a digital oscillator, coupled to the clock generator and to a frequency switching signal input, which generates an oscillating output signal having a frequency which is proportional to the frequency of the clock signal and which is also discretely controllable in accordance with an input frequency switching signal; phase comparison means, for providing the frequency control signal to the oscillator in response to the difference in phase between the oscillating output signal and an input signal; and a detector circuit coupled to the input signal and to the output of the oscillator for comparing the input signal and the oscillating output signal in order to detect whether the input signal and the oscillating output signal are synchronised and for outputting the frequency switching signal to the oscillator in dependence on the result of the comparison.

According to one embodiment of the present invention the oscillator of the discriminator circuit: includes a clock generator where the frequency changes in an analog operation by an impressed voltage or current of an analog, controls the bit length of an accumulated data oscillator, takes an error of the initial oscillation frequency as large as possible within an acceptable range and eliminates the adder for adding the comparison result data ΔSA and the initial data ΔSO.

According to the arrangement as mentioned above, since the bit length is shortened in the accumulated data generator the accumulator scale itself is reduced. Further, since the steps for dividing the additional bit is reduced the steps of the latch for delaying the added result is also reduced. Since it does not have the adder for adding the comparison result data ΔSA and the initial data ΔSO the element reduction effect in the digital oscillator can be increased, since the master clock fCLK is controlled from the phase detector using an analog operation the oscillation frequency in the digital oscillator which is conventionally dispersed so far can be took to analog and the limitation of the frequency resolution in the digital oscillator can be removed.

Additional objects and advantages of the present invention will be apparent to persons skilled in the art from a study of the following description and the accompanying drawings, which are hereby incorporated in and constitute a part of this specification.

For a better understandings of the present invention and many of the attendant advantages thereof, reference will now be made by way of example to the accompanying drawings, wherein:

FIGURE 1 is a block diagram for explaining an oscillator used in one embodiment of the present invention;

FIGURE 2 is a block diagram for explaining an application of the arrangement shown in FIGURE 1;

FIGURE 3 is a block diagram for explaining a concrete example of the analog converter in FIGURE 2;

FIGURE 4 is a block diagram for explaining other application of the arrangement shown in FIGURE 1;

FIGURE 5 is a block diagram illustrating the use of a phase controller with the analog phase detector;

FIGURE 6 is a block diagram of an arrangement in accordance with the present invention utilising the system in FIGURE 5;

FIGURE 7 is a block diagram for explaining a slight adjustment of the oscillation frequency of the oscillator;

FIGURE 8 is a block diagram for explaining other slight adjustment of the oscillation frequency of the oscillator;

FIGURE 9 is a block diagram for showing external converting example of the clock generator used in the present invention;

FIGURE 10 is a block diagram showing a conventional APC circuit;

FIGURE 11 is a block diagram showing a conventional digital oscillator;

FIGURE 12 is a block diagram for explaining a digital APC circuit using FIGURE 11; and

FIGURE 13 is a block diagram for explaining an accumulated data generator in FIGURE 12.

Embodiments of the present invention will be explained hereinafter in reference to the attached drawings.

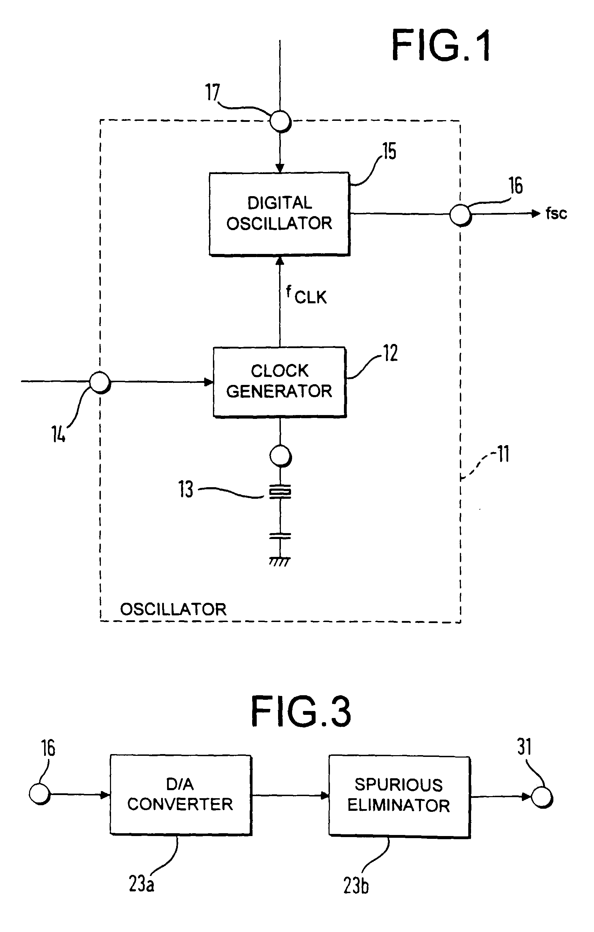

FIGURE 1 shows an ocsillator used in the present invention. In FIGURE 1, the reference numeral 11 denotes a digital oscillator. In the digital oscillator 11 a master clock fCLK is generated by connecting one quartz oscillator 13 to an analog system clock generator 12. An analog control signal is input to the clock generator 12 through a frequency control terminal 14. The master clock fCLK is supplied to a digital oscillator 15, from which the color subcarrier signal fsc is then introduced to an output terminal 16. A control signal for changing the oscillating color subcarrier signal fsc associated with a particular television system is input to the digital oscillator 15 through a control terminal 17.

The detail explanation will be described after. The digital oscillator 11 does not have the input of the comparison result data ΔSA in FIGURE 12, so, it also does not have an adder 127 in FIGURE 12. Since the master clock fCLK changes in analog operations so as to obtain the desirable frequency it will be needless to consider the bit resolution in the digital oscillator 11. Besides, since the frequency jump corresponding to one bit of data does not occur by the complete phase synchronization it is also needless to discuss about the color phase difference detection limit at the one line ending time.

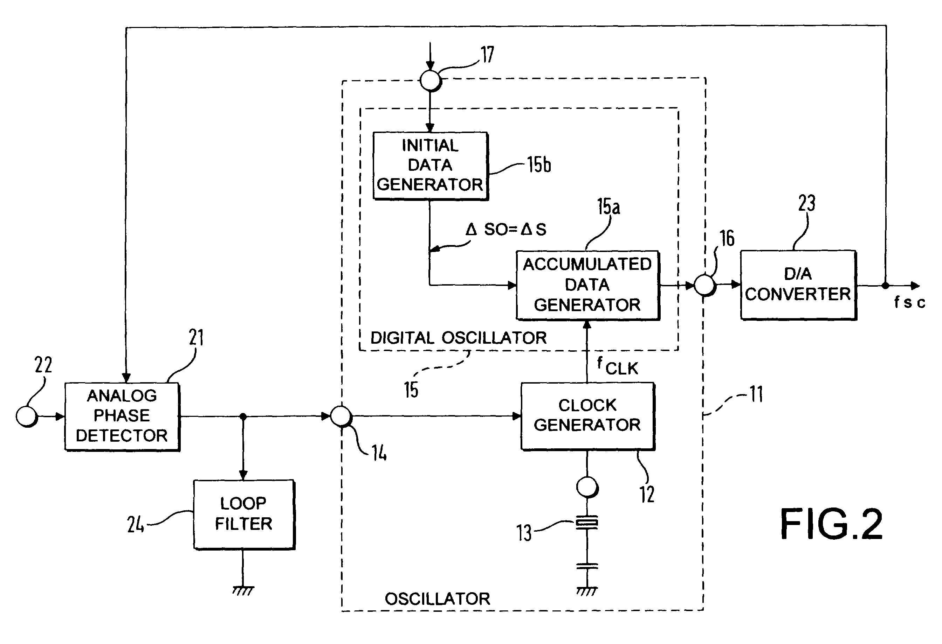

FIGURE 2 shows an example of the case that the system in FIGURE 1 is applied as the APC circuit of the TV receiver, the embodiment is explained hereinafter by using this FIGURE 2. The same component as those shown in FIGURE 1 are assigned with the same marks.

A burst signal divined from a composite video signal is applied to an input terminal 22 of an analog phase detector 21, here, the output of the digital oscillator 11 is phase-compared with the analog conversion signal via an analog converter 23. An output signal which is extracted its low frequency band by a loop filter 24 is connected to a frequency control terminal 14 of a clock generator 12. The clock generator 12 changes the oscillation frequency by a frequency control signal. The oscillation signal obtained from the clock generator 12 is input to the data accumulator 15a composing a digital oscillator 15, as a master clock fCLK. On the other hand, a signal for changing the frequency of the color subcarrier signal fsc is input to an initial data generator 15b composing the digital oscillator 15 from a changing terminal 17. The initial data which is for defining the initial oscillation frequency of the color subcarrier signal fsc changes the initial data ΔSO which is equal to a given sum data ΔS of the according to the changing signal. Since the comparison result data ΔSA is not in the accumulated data of the accumulated data generator 15a the initial data ΔSO is equal to the given sum data ΔS. As explained in the conventional example, in the accumulated data generator 15a the sum data ΔS is added each master clock fCLK. Since it rises an overflow a sawtooth waveform data sequence is obtained apparently, by operating the waveform (sinusoidal waveform) converting to the data sequence a data sequence output having a least distortion is obtained.

An analog output signal which is obtained from the burst signal and the output of the digital oscillator 15 via an analog converter 23 is phase-compared in a phase detector 21, and the comparison result is obtained by the analog. The signal is passed through the loop filter 24 to extract only the low component and supplied to the clock generator 12 as it is analog. In the clock generator 12 the frequency changes very little by the signal, as a result it changes the output frequency of the digital oscillator 16. At the end the phase detector 21 drives the oscillation frequency of the digital oscillator 15 and make it to phase-synchronize with the burst signal wholly. The sum data ΔS only do only controlling the initial oscillation frequency. Since the phase detecting controlling is operated to the master clock fCLK the controlling parameter is divided into two apparently, it is not necessary to add the APC controlling information on the sum data ΔS. Generally speaking, the fsc changing terminal 17 is provided for a coarse adjustment while the frequency control terminal 14 is operated for a fine adjustment.

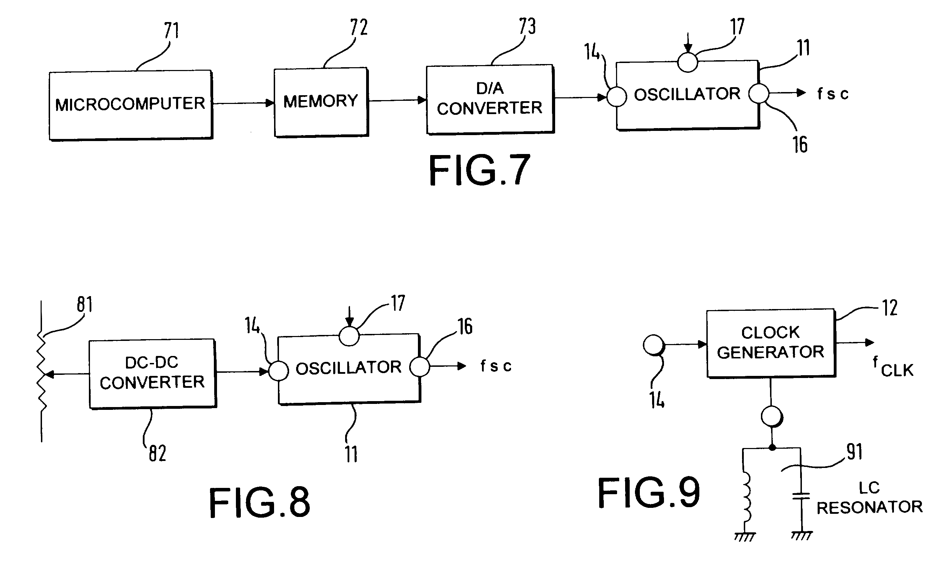

In the conventional system shown in FIGURE 10 since the frequency band of the quartz oscillator circuit 103 is about from ±500 to ±700 Hz compared with that of the color subcarrier signal fsc, if the clock generator 12 in FIGURE 2 has the same ratio that is, for instance, the master clock fCLK is 16 MHz which is four times as much as the frequency of the color subcarrier fsc it can have the frequency band about from ±2 to ±3 KHz. The setup is enough to be corresponded by the analog circuit. Since the master clock is varied in the digital oscillator 15 the error from the frequency of the color subcarrier signal fsc of the initial oscillator by ΔS can be large. If anything, it may be an initial oscillation frequency error extent of the conventional oscillator in FIGURE 9, and it is about from ±5 0 to 100 Hz. If the bit length of the accumulated data generator has an M bit size (M is an integer) to a certain master clock fCLK the oscillation frequency fosc of the digital oscillator 15 can be expressed by the following Equation;

$$fosc = fCLK \times \Delta S / 2^M \qquad (1)$$

Since the sum data ΔS is the integer, if M within the ±100 Hz to the color subcarrier fsc of the four television standards is found. M will be 15 when the master clock fCLK is 16 MHz. The fosc precision is not changed in this extent of the bit length even if it is lengthened about 2 or 3 bits. It's because an integral error which is arouse when the sum data ΔS is sought is contained. Accordingly, if it is 15 bit length it will be possible to decrease about 7 or 9 bits compared to the conventional device, it's about 2/3 extent in the aspect of the ratio. Of course, the latch steps are also decreased in proportion to it.

The initial data ΔSO in the conventional system, as shown in FIGURE 12, will be that M = 22 and the value of the sum data ΔS = 1162247 when it is calculated from the equation (1) in the case of the BG-PAL system. It need almost the same bit length as the accumulating addition of the accumulated data generator 128. However, in this embodiment, the adder is not necessary so, it can get almost the half of the scale reducing effect as a whole system f the digital oscillator 11.

Since the output of the analog phase detector 21 does not have a element of the clock delay, it can be got at real-time. Further, since it also does not have the clock delay factor which was needed for synchronizing the timing of the comparison result data ΔSA and the initial data ΔSO in the adder 127 in the conventional FIGURE 12 the same pull-in time as the APC in FIGURE 10 can be obtained. Accordingly the operation which is took eight fields in FIGURE 11 can be done with four fields in this embodiment, that is, the improvement effect on the visual sense is extremely great.

Here, the construction of the accumulated data generator 15a in FIGURE 2 is the same as an accumulated data generator 128 in FIGURE 12 and the construction example is the same as FIGURE 13. So, its detail explanation will be omitted, but since the bit length composing the circuit is different each other it can not be regarded in the same light as the constructing example in FIGURE 13.

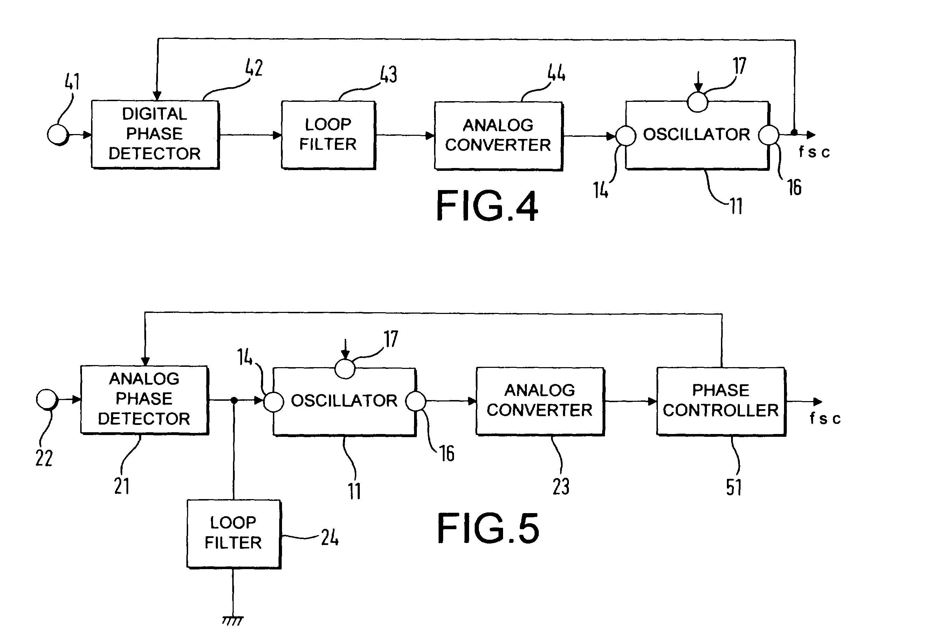

Next, the analog converter 23 in FIGURE 2 is explained by using FIGURE 3. It is a circuit which inputs the data sequence from the accumulated data generator 15a and converts the data into the analog signal. The data sequence from the accumulated data generator 15a is took into the input terminal 16. The input data sequence is converted into the analog signal in a D/A converter 23a. However, since the output signal is still performed a sampling it just converted into a voltage signal. Accordingly, it leaves a lot of spurious components containing an alias behind, so it has to remove them. The spurious components are removed in a spurious rejection circuit 23b. An analog color subcarrier fsc is output to an output terminal 31 from the spurious rejection circuit 23b. The conventional circuit shown in FIGURE 13 does not have the analog converter 23, but the analog output is necessary to take an oscillator 114 in FIGURE 11 into the analog system as a matter of course, and thus the analog converter is necessary as well.

FIGURE 4 shows another system of the APC circuit useful in the present invention, which is incorporated with a digital phase detector without the use of the analog phase detector. A burst signal of the digital data which is converted in the A/D converter (not shown) is input through an input terminal 41 to one input of a digital phase detector 42, a digital output from tho output terminal 16 of an oscillator 11 is applied to the other input of the digital phase detector 42 to be phase-detected. The detected output data is supplied to an analog converter 44 via a loop filter 43. The analog conversion signal is supplied to a frequency control input terminal 14 of the oscillator 11 to control the oscillation frequency of the clock generator 12. According to the above configuration, the clock is controlled in analog operations. Thus it is possible to reduce the bit length of the oscillator 11 and thus decreasing the cost of the oscillator 11.

However, in the case of FIGURE 4 since the phase-detection output represents a digital signal the frequency jump corresponding to one bit of data as explained in reference to FIGURE 12 occurs. The degree of the frequency jump is depend on the bit size of the analog conversion or phase-detection output. But, those matters can be improved changing the positional order of the loop filter 43 and the analog conversion circuit 44 by configuring in analog operations the loop filter 43 or properly adjusting the characteristics of the loop filter 43. At least, since delays such as those caused in the adder 127 in the conventional system as shown in FIGURE 12 do not occur in the system, as shown in FIGURE 4, the APC pull-in time is improved in compared to that in the conventional system of FIGURE 12.

Thus, the APC circuits according to the present invention do not lower the essential effect of the circuits though there is a slight difference in the digital or analog configuration of the phase detector.

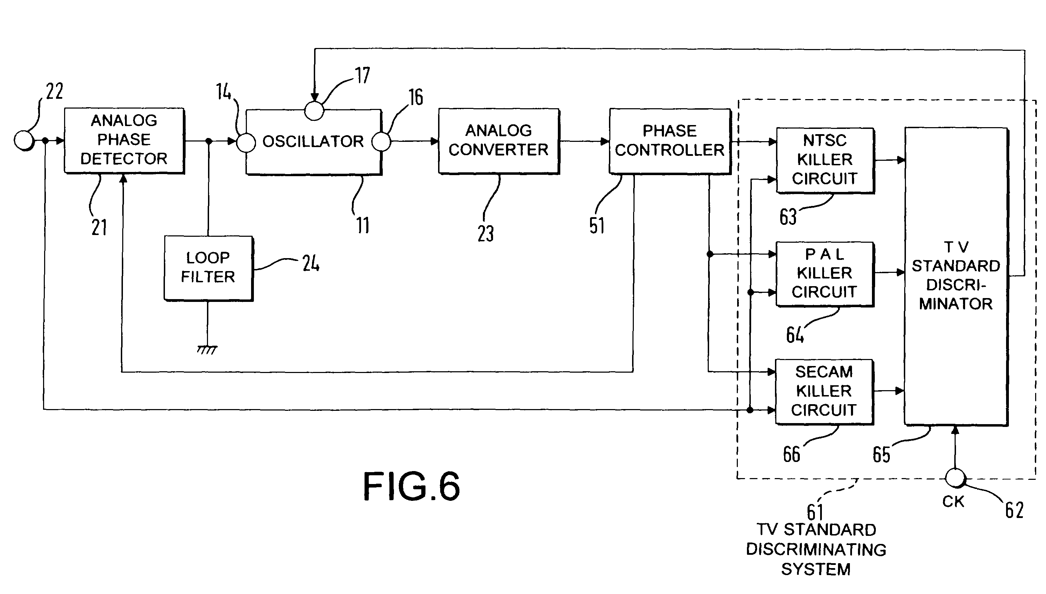

Referring now to FIGURE 5, still another system of the APC circuit useful in the present invention will be explained. The system shown in FIGURE 5 is a modification in which a phase controller 51 is added for processing the control signal to the analog phase detector 21, as shown in FIGURE 2. In a specific application, it is desired to make the phase of the signal supplied to the phase detector different from the phase of the signal used in other circuits. In this case, the phase controller 51 is located to receive the analog conversion signal output from the analog converter 23. An output of the phase controller 51 is fed back to the phase detector 21. The phase controller 51 thus outputs another phase-controlled signal as the color subcarrier signal fsc. Here, when a phase controller such as the phase controller 51 is used in the system as shown in FIGURE 4 the phase controller can be inserted between the output terminal 16 of the oscillator 11 and the phase detector 42.

Referring now to FIGURE 6, a discriminator circuit in accordance with the invention, which uses the system as shown in FIGURE 5 will be described. Further, the function of the fsc changing terminal 17 in television receivers will be also explained. Accordingly, In FIGURE 6 the analog phase detector is illustrated based the circuit configuration of analog phase detectors.

In FIGURE 6, the output of the oscillator 11 is converted into analog signals in the analog converter 23 and then input to the phase controller 51. One output of the phase controller 51 is fed back to the analog phase detector 21. A television standard discrimination system 61 is provided for receiving the output signal from the phase controller 51, the input burst signal on the input terminal 22 and a clock signal CK through a clock input terminal 62. The output of the discrimination system 61, i.e., an fsc changing signal is fed back to the control terminal 17 of the oscillator 11. The television standard discrimination system 61 is provided with an NTSC killer circuit 63 and a PAL killer circuit 64 which receive the burst signal. The phase detector 51 provides the NTSC killer circuit 63 and the PAL killer circuit 64 with respective suitably phase-controlled color subcarrier signals fsc. The outputs of the killer circuits 63 and 64 are supplied to a television standard discrimination circuit 65 for discriminating the standard of the presently received signal.

The NTSC killer circuit 63 discriminates whether the presently received signal is of the NTSC signal or not by processing the phase-controlled color subcarrier fsc and the burst signal. The PAL killer circuit 64 discriminates in the same manner as the NTSC killer circuit 63. However, since the burst signal at the PAL system has different phases at line by line the PAL killer circuit 64 provides the color subcarrier signals fsc suitably phase-controlled in synchronism with the phase change of the burst signal. Since the phase control as mentioned above is needed for the processing of the color subcarrier signal fsc of the TV receiver the phase controller is located between the oscillator 11 and the phase detector 21. Besides, such a phase control is also needed for the color subcarrier signal fsc supplied to demodulators. The clock signal CK input to the television standard discrimination circuit 65 is of a four field cycle clock signal, thus the television standard discrimination circuit 65 generates the fsc changing signal based on the unit of the four field cycle. For instance, when a signal is of neither the NTSC system nor the PAL system the frequency of the color subcarrier signal fsc is changed every four fields. In the initial data generator 15b the value of the sum data $\Delta S$ is changed based on the signal changing every four field of the color subcarrier signal fsc. Thus, the television standard of the presently received chrominance signal is discriminated.

Here, if the PAL standard signal is received the PAL killer circuit 64 outputs a signal corresponding to the PAL standard signal. The television standard discrimination circuit 65 discriminates the output signal of the PAL killer circuit 64 as a signal of the PAL system in referring the output of the NTSC killer circuit 63 or the color subcarrier signal fsc. At the time, the fsc changing signal is deactivated and the current frequency of the color subcarrier signal fsc is maintained. Further, a PAL demodulating circuit (not shown) is activated for reproducing a PAL demodulating color difference signal. Similar operations are also carried out in the case of receiving the NTSC standard signal.

Since the SECAM standard system carried out processings different from the PAL and the NTSC standard system, the operation for receiving the SECAM standard signal is basically not related to the oscillation of the color subcarrier signal fsc. However, if the fsc oscillator 11 changes the oscillation frequency at the SECAM receiving time the chrominance signal displayed on a screen is affected by a leakage signal of the color subcarrier fsc. So. in the SECAM receiving time the color subcarrier signal fsc is usually fixed with that of the PAL or the NTSC system. Thus, it is needed to monitor killer information of the SECAM system at the television standard discrimination circuit 65. When the receiver is fully adapted to receive the SECAM system the killer information of the SECAM killer circuit 66 is input to the television standard discrimination circuit 65 and the comprehensive television standard discrimination is carried out. Even if such full multi standards ready color television receiver adapted for all standards including the SECAM standard is considered, the presently received standards is sure to be automatically discriminated by cyclically performing the change of the color subcarrier signal fsc.

In the case of the television receiver for South America; the sum data ΔS can be prepared for the NTSC system and M-PAL and N-PAL system, and in case of the television receiver for Europe or Asia, BG or others-PAL and NTSC can be changed.

On the other hand, in the case of the PAL system, its color subcarrier is interleaved between the horizontal frequencies by means of so-called 1/4 line offset techniques. Since the burst signal is phase-controlled to 90 degree every line apparent frequencies are not unified. Since sideband components caused by the operation are combined on a frequency axis if the pull-in frequency range of the color subcarrier signal fsc at the receiving side is wide the sideband components cause a malfunction of fault-locking to the sideband components. So, for oscillating the color subcarrier signal fsc a device such as a quartz oscillator which has a stable reference frequency, a high degree of Q and around $10^{-6}$ (i,e, PPM) order in errors of the frequency variable limits and the initial oscillation frequency could be used.

Actually, in the case of the conventional quartz oscillator circuit 103 in FIGURE 10, by means of that the damping resistance on the terminal provided for connecting to the PAL system quartz oscillators is lowered to decrease the Q of the circuit, and the frequency band is made so wide that the variable limits is checked not to expand to the frequency causing the fault-locking. Hereinafter some measures applied in the present invention will be described in detail.

In the digital oscillator of the present invention, the oscillation frequency of the clock generator 12 is fixed, i.e., unchanged even if it generates either frequency needed for the color subcarrier signals fsc of the above-mentioned four standards. However, since the ΔS of an initial data generator 15b is controlled by a television standard discriminator 65 the oscillated frequency can be discriminated between the PAL and the others. Accordingly, the frequency band of the oscillator 11 in the case of the PAL standard is narrower than the that of the other standards, so that it is able to carried out an adaptive control. Generally, the frequency band of the oscillator 11 is defined by not only a damping resistance but also a vector composition ratio.

About the configuration of the oscillator 11, see the Japanese patent application: Tokkai-Hei 2-200002 in the title of "Voltage Controlled Oscillator". By making the vector composition ratio small the frequency variable limits can be controlled from outside. So, when the signal is oscillated with PAL frequency the vector composition ratio may be controlled or changed to become small. Of course, when the signal is oscillated with PAL frequency a specific variable limits is set up and when it is oscillated with the other color subcarrier signals fsc the variable limits can be widen.

The embodiment mentioned above explains about the case of that the system in FIGURE 1 is input to the PLL loop. The case of that the system is not input to the PLL loop will explained hereinafter.

In some applications the oscillation frequency of the oscillator can be changed in a step-wise manner and so that a frequency-locking is not required. For instance, there is an application to an SIF (sound intermediate frequency) handling in the multi-standards ready color television receiver. There are four television standards of the SIF handling in television signals. In Japan the 4.5 Mhz is used for the SIF, while globally there are also used 5.5 MHz. 6.0 MHz and 6.5 MHz for the SIF. When these SIF signals are received in one television receiver these are frequency-converted to a single IF so that it is able to be processed by only one audio signal detection circuit. There are many ways in the frequency arrangement. For instance, if the second IF next to the first frequency conversion is set to 500 KHz the television receiver is required to accommodate four local oscillation frequencies of 4.0 MHz, 5.0 MHz, 5.5 MHz and 6.0 MHZ for each of the 4.5 MHz SIF, the 5.5 MHz SIF, the 6.0 MHz SIF and the 6.5 MHz SIF. The present invention is suitable for applying to such an SIF local oscillator. As the second IF it will be enough to have a tracking efficiency of 0.1% order for converting down the frequency of the received signal to about 500 KHz. Generally, a reference oscillator is provided for the usage. Then some of integer-times frequencies are produced from the reference frequency by using a frequency synthesizer and thus the produced frequencies are used as respective local oscillation signals. In this case, many frequency dividers and a loop filter are required since the frequency synthesizer is itself arranged in a PLL configuration.

On the other hand, the oscillator according to the present invention has an advantage of that it can generate arbitrary frequencies from the reference signal and it does not require to use such a loop filter. In other words, in the conventional system the PLL technique is used for overcoming the unstableness of oscillation frequency due to dispersion of time constant obtained IC configuration. On the other hand, the present invention system can provide a good precision of the reference frequency without the use of the PLL technique. Further, since a spectrum of the signal obtained from the digital oscillator 11 has the same precision as the clock generator 12 for the reference signal and also it provides an extremely pure color presentation with less spurious. Although the present invention does not need the APC (PLL) loop, the initial oscillation error in the clock generator 12 or the initial oscillation data error caused by controlling the bit length of the accumulated data generator 15a may cause a slight aberration in the tracking frequency. Referring now to FIGURES 7 and 8, a compensation of the aberration will be is described. The choice of the receptions with which frequency among the above-mentioned four television standard SIFs will be determined by an indication from a microcomputer. So, if proper compensations corresponding to these four television standards are done it is possible to cancel the error.

In FIGURE 7, compensation data are provided from a microcomputer 71 to a memory 72. An output of the memory 72 is supplied to a D/A converter 73. An analog output from the D/A converter 73 is supplied to a frequency control terminal 14 of the oscillator 11. In this case, the clock frequency is controlled by an analog voltage or current signal converted from the compensation data from the microcomputer 71. The memory 72 can be of either a RAM or a ROM. The compensation data can be prepared by adjusting once and then applied to the microcomputer every time. Or the compensation data can be stored in a ROM in advance and then are selectively read from the ROM in response to a changing signal of the four standard SIFs. Further, when the SIF frequency changing using the changing terminal 17 is performed with a sufficient precision a control data from the microcomputer 71 can be used for adjustment of the master clock fCLK. Thus, it can output different frequencies with a high precision and a high purity. In manufacturing lines since the data is managed by microcomputers the adjustment process does not need skills. So it is extremely good.

When it is unable to adjust with the aid of microcomputers the adjustment can be manually adjusted as shown in FIGURE 8. In this case, the aberration to each frequency or the master clock fCLK are adjusted by the aid of a variable resistor 81. The adjusted data are then applied from the variable resistor 81 to the frequency terminal 14 of the oscillator 11 through a DC-DC converter 82. Here, when the clock generator 12 is the type capable of direct controlling the DC-DC converter 82 can be omitted. In this case there is also an advantage that the adjusting range is arbitrarily set up and that a capacitive element involving to the oscillation is not to be directly operated.

Further, as the resonant element in the clock generator 12 to be used for television receivers the quartz oscillator is employed in the above explanation. However any other element may be used provided it has a good frequency selectivity. One example of such elements is shown in FIGURE 9. A parallel LC resonant circuit 91 is used in the example of FIGURE 9. Of course, it can be a series resonant circuit. It may well that a certain resonant element is used in the clock generator 15 and its oscillation frequency is changed by the internal circuit according to the control signal provided through the control terminal 14.

In the above descriptions since the present invention is explained in reference to television receivers the accumulated data generator 15a is employed for illustrative examples. However, the accumulated data generator is not always necessary in some other applications. Although it is completely natural that the color subcarrier signal fsc of the television signal differs in different television standards, the frequency of the color subcarrier signal fsc is inherently off-set so as not to have an integer ratio of correlation with a horizontal frequency. Thus there is no such integer ratio of correlation among the color subcarrier signals fsc of the different television atandards. However, there may be a case of having such a correlation. In such a case, the accumulated data generator can be replaced with the counter. As mentioned in the above document, "Digital Television Standard Waveform Generator", pp. 295-304, the master clock fCLK can be counted to use for reading out the waveform data as addresses so that the same effect will be obtained. That is, if the data sequence changing in the sawtooth-waveform state in either of digital oscillators or counters the result as mentioned above will be obtained.

However, there are two ways in the usage of such counters. One is to change the frequency dividing ratio for changing the maximum value, i.e., the amplitude of the generated data sequence. In this case since the frequency dividing ratio can be arbitrarily changed the very low frequency can be set up. The other way is to fix the count cycle of the data sequence but changing the bit to be read-out. In this case the counter is of a $2^L$ (L is an integer) binary counter and fixes the generating cycle of the data sequence. When the counter output is are read out starting from the MSB the data sequence at the lowest frequency is obtained. While when the data sequence is read out starting from the next bit of the MSB the twice the frequency is obtained.

Accordingly, the above construction is limited to the case of generating the frequency which will changed at a ratio of $2^K$ (K is a whole number). When generating the frequency sequence which has a ratio very close to the $2^K$ but slightly different from the ratio, it may enough to take the frequency variable limits of the clock generator widely in corresponding to the errors. Then it can obtain the same effect without the use of accumulators.

Further, the present invention can be applied to a field of generating the many frequencies from one master clock with high precision. In such a circuit it will be needed a circuit for determining which frequency among these frequencies is used for an end oscillation frequency. In television receivers killer circuits are served for the determination. While in general, circuits for detecting the phase detecting state are served for the detection. Furthermore, the determining element differs according to the type of function required for devices applied with the present invention. Here, the determining element will defined widely as circuits for detecting the phase detecting state.

According to the present invention the digital oscillator with reduced circuit scale and low cost can be realized. Also by using the oscillator for the APC (PLL) circuit the pull-in time can be shortened.

As described above, the present invention can provide an extremely preferable oscillator.

While there have been illustrated and described what are at present considered to be preferred embodiments of the present invention. it will be understood by those skilled in the art that various changes and modifications may be made, and equivalents may be substituted for elements thereof without departing from the true scope of the present invention. In addition, many modifications may be made to adapt a particular situation or material to the teaching of the present invention without departing from the central scope thereof. Therefor, it is intended that the present invention not be limited to the particular embodiment disclosed as the best mode contemplated for carrying out the present invention, but that the present invention includes all embodiments falling within the scope of the appended claims.

**Claims**

1. A discriminator circuit, characterised in that it comprises:

    an oscillator (11), comprising a clock generator (12) for generating a clock signal having a frequency controllable by means of a frequency control signal, and a digital oscillator (15), coupled to the clock generator (12) and to a frequency switching signal input, which generates an oscillating output signal having a frequency which is proportional to the frequency of the clock signal and which is also discretely controllable in accordance with an input frequency switching signal;
    phase comparison means, for providing the frequency control signal to the oscillator (11) in response to the difference in phase between the oscillating output signal and an input signal; and
    a detector circuit (61) coupled to the input signal and to the output of the oscillator (11) for comparing the input signal and the oscillating output signal in order to detect whether the input signal and the oscillating output signal are synchronised and for outputting the frequency switching signal to the oscillator (11) in dependence on the result of the comparison.

2. A discriminator circuit as claimed in claim 1, wherein the digital oscillator (15) has a circuit for generating an arbitrary waveform of the oscillating output signal.

3. A discriminator circuit as claimed in claim 1 or 2, wherein the clock generator (12) has input terminals provided for connections with a resonant element (13) and the frequency control signal.

4. A discriminator circuit as claimed in any preceding claim, wherein the digital oscillator comprises an initial data generator (15b) and an accumulated data generator (15a) for accumulating the initial data.

5. A discriminator circuit as claimed in claim 4, wherein the accumulated data generator (15a) comprises an accumulator and a latch.

6. A discriminator circuit as claimed in claim 4, wherein the accumulated data generator (15a) is comprised of a counter.

7. A discriminator circuit as claimed in any preceding claim, wherein the phase comparison means comprises:

    a converting circuit (23) for converting output of the digital oscillator into an analog signal;
    an analog phase detector (21) for detecting the phase difference between the analog signal output from the converting circuit (23) and the input signal; and
    a loop filter (24) for filtering the output of the analog phase detector (21) and for outputting the frequency control signal for the oscillator (11).

8. A discriminator circuit as claimed in claim 7, wherein the converting circuit (23) comprises a D/A converter (23a) and a spurious rejection circuit (23b).

9. A discriminator circuit as claimed in claim 7 or 8, wherein the output of the converting circuit (23) is connected to the analog phase detector (21) via a phase controller (51).

10. A discriminator circuit as claimed in one of claims 1-6, wherein the phase comparison means comprises:

    a digital phase detector (42) for detecting the phase difference between the output of the digital oscillator (15) and the input signal;
    a digital filter (43) for filtering the detected output of the phase detector;
    an analog conversion circuit (44) for converting the output of the digital filter into an analog signal, and for supplying the analog signal to the oscillator (11) as the frequency control signal.

11. A discriminator circuit as claimed in claim 10, wherein the output of the digital oscillator (15) is input to the digital phase detector (42) via a phase controller.

12. A discriminator circuit as claimed in any preceding claim, wherein the frequency band of the clock generator (12) is varied in accordance with the frequency switching signal.

13. A discriminator circuit as claimed in any preceding claim, wherein the input signal is a television signal and the detector circuit (61) is a circuit for discriminating the television system.

14. A discriminator circuit as claimed in claim 13, wherein the detector circuit (61) repeatedly alters the output frequency switching signal until reception of a predetermined television system has been detected.

15. A discriminator circuit as claimed in any preceding claim, wherein a phase controller (51) is coupled between the output of the oscillator (11) and the input of the detector circuit (61).

16. A discriminator circuit as claimed in any preceding claim, further comprising a memory circuit for storing an external digital data, and means for converting the output of the memory to an analog signal to be used for controlling the clock frequency.

17. A discriminator circuit as claimed in any preceding claim, wherein the clock signal frequency is controlled by an external DC voltage or DC current.

**Revendications**

1. Un circuit discriminateur, caractérisé en ce qu'il comprend :

   un oscillateur (11), comprenant un générateur d'horloge (12) pour produire un signal d'horloge présentant une fréquence pouvant être commandée au moyen d'un signal de commande de fréquence, et un oscillateur numérique (15), couplé au générateur d'horloge (12) et à l'entrée d'un signal de commutation de fréquence, lequel produit un signal de sortie oscillant présentant une fréquence qui est proportionnelle à la fréquence du signal d'horloge et qui peut également être commandée de manière discrète conformément à un signal de commutation de fréquence d'entrée ;
   des moyens de comparaison de phase, pour fournir le signal de commande de fréquence à l'oscillateur (11) en réponse à la différence de phase entre le signal de sortie oscillant et un signal d'entrée ; et
   un circuit détecteur (61) couplé au signal d'entrée et à la sortie de l'oscillateur (11) pour comparer le signal d'entrée et le signal de sortie oscillant de manière à détecter si le signal d'entrée et le signal de sortie oscillant sont synchronisés et pour délivrer le signal de commutation de fréquence à l'oscillateur (11) en dépendance du résultat de la comparaison.

2. Un circuit discriminateur tel que revendiqué à la revendication 1, dans lequel l'oscillateur numérique (15) présente un circuit pour produire une forme d'onde arbitraire du signal de sortie oscillant.

3. Un circuit discriminateur tel que revendiqué à la revendication 1 ou 2, dans lequel le générateur d'horloge (12) présente des bornes d'entrée prévues pour des liaisons avec un élément résonnant (13) et le signal de commande de fréquence.

4. Un circuit discriminateur tel que revendiqué dans une quelconque revendication précédente, dans lequel l'oscillateur numérique comprend un générateur de données initiales (15b) et un générateur de données accumulées (15a) pour accumuler les données initiales.

5. Un circuit discriminateur tel que revendiqué à la revendication 4, dans lequel le générateur de données accumulées (15a) comprend un accumulateur et un organe de verrouillage.

6. Un circuit discriminateur tel que revendiqué à la revendication 4, dans lequel le générateur de données accumulées (15a) est composé d'un compteur.

7. Un circuit discriminateur tel que revendiqué dans une quelconque revendication précédente, dans lequel les moyens de comparaison de phase comprennent :

   un circuit de converssion (23) pour convertir la sortie de l'oscillateur numérique en un signal analogique ;
   un détecteur de phase analogique (21) pour détecter la différence de phase entre le signal analogique sortant du circuit de conversion (23) et le signal d'entrée ; et
   un filtre en boucle (24) pour filter la sortie du détecteur de phase analogique (21) et pour délivrer le signal de commande de fréquence pour l'oscillateur (11).

8. Un circuit discriminateur tel que revendiqué à la revendication 7, dans lequel le circuit de conversion (23) comprend un convertisseur N/A (23a) et un circuit de rejet de faux (23b).

**9.** Un circuit discriminateur tel que revendiqué à la revendication 7 ou 8, dans lequel la sortie du circuit de conversion (23) est reliée au détecteur de phase analogique (21) par l'intermédiaire d'un organe de commande de phase (51).

**10.** Un circuit discriminateur tel que revendiqué dans une des revendications 1 à 6, dans lequel les moyens de comparaison de phase comprennent :

un détecteur de phase numérique (42) pour détecter la différence de phase entre la sortie de l'oscillateur numérique (15) et le signal d'entrée ;
un filtre numérique (43) pour filtrer la sortie détectée du détecteur de phase ;
un circuit de conversion analogique (44) pour convertir la sortie du filtre numérique en un signal analogique, et pour appliquer le signal analogique à l'oscillateur (11) sous la forme du signal de commande de fréquence.

**11.** Un circuit discriminateur tel que revendiqué à la revendication 10, dans lequel la sortie de l'oscillateur numérique (15) est appliquée au détecteur de phase numérique (42) par l'intermédiaire d'un organe de commande de phase.

**12.** Un circuit discriminateur tel que revendiqué dans une quelconque revendication précédente, dans lequel la bande de fréquence du générateur d'horloge (12) est modifiée conformément au signal de commutation de fréquence.

**13.** Un circuit discriminateur tel que revendiqué dans une quelconque revendication précédente, dans lequel le signal d'entrée est un signal de télévision et le circuit détecteur (61) est un circuit pour discriminer le système de télévision.

**14.** Un circuit discriminateur tel que revendiqué à la revendication 13, dans lequel le circuit détecteur (61) altère de manière répétée le signal de commutation de fréquence de sortie jusqu'à ce qu'ait été détecté la réception d'un système de télévision prédéterminé.

**15.** Un circuit discriminateur tel que revendiqué dans une quelconque revendication précédente, dans lequel un organe de commande de phase (51) est couplé entre la sortie de l'oscillateur (11) et l'entrée du circuit détecteur (61).

**16.** Un circuit discriminateur tel que revendiqué dans une quelconque revendication précédente, comprenant en outre un circuit mémoire pour stocker une donnée numérique externe, et des moyens pour convertir la sortie de la mémoire en un signal analogique devant être utilisé pour commander la fréquence d'horloge.

**17.** Un circuit discriminateur tel que revendiqué dans une quelconque revendication précédente, dans lequel la fréquence du signal d'horloge est commandée par une tension de courant continu externe ou par un courant continu externe.

**Patentansprüche**

**1.** Diskriminatorschaltung, dadurch gekennzeichnet, dass sie umfasst:

einen Oszillator (11), der einen Taktgenerator (12) zum Erzeugen eines Taktsignals enthält, dessen Frequenz man mit einem Frequenzsteuersignal steuern kann, und einen digitalen Oszillator (15), der mit dem Taktgenerator (12) und einem Frequenzumschaltsignal-Eingang verbunden ist und ein Oszillatorausgangssignal erzeugt, dessen Frequenz proportional zur Frequenz des Taktsignals ist, und der ebenfalls abhängig von einem eingegebenen Frequenzumschaltsignal diskret steuerbar ist;
eine Phasenvergleichsvorrichtung, die das Frequenzsteuersignal für den Oszillator (11) abhängig von der Phasendifferenz zwischen dem Oszillatorausgangssignal und einem Eingangssignal liefert; und
eine Detektorschaltung (61), die mit dem Eingangssignal und dem Ausgangssignal des Oszillators (11) verbunden ist und das Eingangssignal und das Oszillatorausgangssignal vergleicht, um zu erkennen, ob das Eingangssignal und das Oszillatorausgangssignal synchronisiert sind, und abhängig vom Ergebnis des Vergleichs das Frequenzumschaltsignal an den Oszillator (11) ausgibt.

**2.** Diskriminatorschaltung nach Anspruch 1, wobei der digitale Oszillator (15) eine Schaltung aufweist, die einen beliebigen Kurvenverlauf des Oszillatorausgangssignals erzeugt.

**3.** Diskriminatorschaltung nach Anspruch 1 oder 2, wobei der Taktgenerator (12) Eingangsanschlüsse hat, die für Verbindungen mit einem Resonanzbauteil (13) und dem Frequenzsteuersignal bereitgestellt sind.

**4.** Diskriminatorschaltung nach irgendeinem vorhergehenden Anspruch, wobei der digitale Oszillator einen Anfangsdatengenerator (15b) und einen Sammeldatengenerator (15a) enthält, der die Anfangsdaten sammelt.

**5.** Diskriminatorschaltung nach Anspruch 4, wobei der Sammeldatengenerator (15a) einen Akkumulator und einen Zwischenspeicher enthält.

**6.** Diskriminatorschaltung nach Anspruch 4, wobei der Sammeldatengenerator (15a) aus einem Zähler besteht.

**7.** Diskriminatorschaltung nach irgendeinem vorhergehenden Anspruch, wobei die Phasenvergleichsvorrichtung umfasst:

eine Umsetzschaltung (23), die das Ausgangssignal des digitalen Oszillators in ein analoges Signal umsetzt;
einen analogen Phasendetektor (21), der die Phasendifferenz zwischen dem Analogsignal, das die Umsetzschaltung (23) ausgibt, und dem Eingangssignal erfasst; und
ein Schleifenfilter (24), das das Ausgangssignal des analogen Phasendetektors (21) filtert und das Frequenzsteuersignal für den Oszillator (11) ausgibt.

**8.** Diskriminatorschaltung nach Anspruch 7, wobei die Umsetzschaltung (23) einen D/A-Umsetzer (23a) und eine Störunterdrückungsschaltung (23b) umfasst.

**9.** Diskriminatorschaltung nach Anspruch 7 oder 8, wobei der Ausgang der Umsetzschaltung (23) über einen Phasenregler (51) mit dem analogen Phasendetektor (21) verbunden ist.

**10.** Diskriminatorschaltung nach irgendeinem der Ansprüche 1 bis 6, wobei die Phasenvergleichsvorrichtung umfasst:

einen digitalen Phasendetektor (42), der die Phasendifferenz zwischen dem Ausgangssignal des digitalen Oszillators (15) und dem Eingangssignal erfasst;
ein Digitalfilter (43), das das erfasste Ausgangssignal des Phasendetektors filtert;
eine Analog-Umsetzschaltung (44), die das Ausgangssignal des Digitalfilters in ein Analogsignal umsetzt und das Analogsignal als Frequenzsteuersignal in den Oszillator (11) einspeist.

**11.** Diskriminatorschaltung nach Anspruch 10, wobei das Ausgangssignal des digitalen Oszillators (15) über einen Phasenregler in den digitalen Phasendetektor (42) eingegeben wird.

**12.** Diskriminatorschaltung nach irgendeinem vorhergehenden Anspruch, wobei das Frequenzband des Taktgenerators (12) gemäß dem Frequenzumschaltsignal verändert wird.

**13.** Diskriminatorschaltung nach irgendeinem vorhergehenden Anspruch, wobei das Eingangssignal ein Fernsehsignal und die Detektorschaltung (61) eine Schaltung ist, die die Fernsehsysteme unterscheidet.

**14.** Diskriminatorschaltung nach Anspruch 13, wobei die Detektorschaltung (61) wiederholt das ausgegebene Frequenzumschaltsignal ändert, bis der Empfang eines vorbestimmten Fernsehsystems erkannt wird.

**15.** Diskriminatorschaltung nach irgendeinem vorhergehenden Anspruch, wobei ein Phasenregler (51) zwischen den Ausgang des Oszillators (11) und den Eingang der Detektorschaltung (61) geschaltet ist.

**16.** Diskriminatorschaltung nach irgendeinem vorhergehenden Anspruch, zudem umfassend eine Speicherschaltung, die externe Digitaldaten speichert, und eine Vorrichtung, die das Ausgangssignal des Speichers in ein Analogsignal umsetzt, das zum Steuern der Taktfrequenz verwendet wird.

**17.** Diskriminatorschaltung nach irgendeinem vorhergehenden Anspruch, wobei die Taktsignalfrequenz mit einer äußeren Gleichspannung oder einem äußeren Gleichstrom gesteuert wird.

# FIG.1

# FIG.3

FIG.2

EP 0 718 979 B1

EP 0 718 979 B1

FIG.4

FIG.5

FIG.6

EP 0 718 979 B1

## FIG.7

MICROCOMPUTER — 71

MEMORY — 72

D/A CONVERTER — 73

OSCILLATOR — 11

— 14

— 17

— 16

f s c

## FIG.8

DC-DC CONVERTER — 82

— 81

OSCILLATOR — 11

— 14

— 17

— 16

f s c

## FIG.9

CLOCK GENERATOR — 12

— 14

f CLK

LC RESONATOR — 91

FIG.10

FIG.11

FIG.12

EP 0 718 979 B1

FIG.13